# DEMANDE DE BREVET EUROPEEN

(11) **EP 0 758 691 A1**
(43) Date de publication de la demande: **19.02.1997**
(21) Numéro de dépôt: 96401728.9
(22) Date de dépôt: 05.08.1996
(51) Int. Cl.: C30B 23/02

(54) **Procédé de gravure d'un substrat par jets chimiques**

(30) Priorité: 10.08.1995 FR 9509728
(71) Demandeur: Alcatel Optronics, 75008 Paris (FR)
(72) Inventeur: Goldstein, Leon, 92370 Chaville (FR); Gentner, Jean Louis, 91190 Gif sur Yvette (FR); Jarry, Philippe, 94370 Sucy en Brie (FR)
(74) Mandataire: Pothet, Jean Rémy Emile Ludovic

(57) **Abrégé**

Pour facilier la reprise d'épitaxie par jets moléculaires après gravure d'un substrat ou d'une couche épitaxiale, le procédé de gravure s'effectue dans l'utravide et consiste à produire au moins deux jets chimiques simultanés et convergeant vers le substrat ou la couche, les jets étant formés de substances capables de réagir chacun avec des éléments du substrat ou de la couche de natures différentes pour former des composés volatils.

Application notamment à la fabrication de composants photoniques et optoélectroniques.

## Description

L'invention se situe dans le domaine de la fabrication de composants intégrés et concerne notamment la fabrication de composants semiconducteurs utilisés en optoélectronique.

Dans le domaine des composants photoniques ou optoélectroniques intégrés apparaît le besoin de former sur un substrat un nombre de plus en plus grand de couches de compositions ou de dopages différents. La fabrication de tels composants nécessite donc généralement de nombreuses successions d'opérations de croissance par épitaxie et de gravure.

Le procédé d'épitaxie par jets moléculaires est bien adapté notamment pour faire croître des couches très minces et très nombreuses. Selon cette technique, la croissance s'opère sous un vide très poussé généralement compris entre 10⁻² et 10⁻¹⁰ Pa, appelé ultravide, dans lequel on provoque l'évaporation simultanée des éléments constituant la couche à déposer, éventuellement accompagnée d'impuretés dopantes. Or, jusqu'à présent, les opérations de gravure s'effectuent au dehors de la chambre d'épitaxie. Après avoir extrait le substrat de la chambre, on lui applique un des procédés de gravure éprouvé, tel que la gravure chimique en phase liquide ou la technique dite de gravure sèche : gravure par ions réactifs ou gravure par faisceaux ioniques réactifs. La gravure chimique en phase liquide présente cependant l'inconvénient de ne pas être homogène et donc de ne pas être adaptée à la fabrication de tranches de grande surface. La gravure sèche permet la gravure de composés semiconducteurs avec un bon contrôle des profondeurs gravées et une bonne homogénéité sur des substrats de grandes dimensions. Elle présente cependant un certain nombre de limitations :
- couche résiduelle amorphisée de fond de gravure ayant une épaisseur comprise en 10 et 100 nanomètres,
- nécessité du retrait de la couche amorphe par chimie humide,
- nécessité d'éliminer des produits de polymérisation formés pendant la gravure,
- nécessité de remise à l'air des plaquettes gravées avant reprise d'épitaxie.

Il est par conséquent souhaitable de pouvoir effectuer des opérations de gravure dans le réacteur servant à l'épitaxie par jets moléculaires tout en restant dans les conditions de l'ultravide afin d'éviter le dépôt d'impuretés qui nécessiterait une étape de préparation supplémentaire.

Dans le cas de substrats constitués d'alliages semiconducteurs de type III-V tels que InP et GaAs, des essais de gravures dans l'ultravide ont été effectués au moyen de jets chimiques de trichlorure de phosphore PCl₃ ou de trichlorure d'arsenic A_{S}Cl₃, en élevant la température du substrat entre 500 et 540°C. La gravure est obtenue par réaction chimique entre le composé III-V et le trichlorure dont les produits de réactions sont volatils à cette température. Cette approche chimique en ultravide ne permet pas néanmoins d'éliminer certains dopants ou impuretés tels que le silicium, le carbone, l'oxygène ou le soufre qui ne réagissent pas avec les composés chlorés. L'accumulation progressive de ces dopants ou impuretés en surface pendant la gravure perturbe cette dernière et se traduit par une forte rugosité de fond de gravure incompatible avec une bonne qualité de reprise d'épitaxie.

Il est à noter que le problème qui vient d'être évoqué dans un contexte particulier va généralement se poser dans tous les cas où l'on cherche à réaliser des gravures par jets moléculaires d'un substrat ou de couches épitaxiales de compositions complexes. Par contre, ce problème est moins sensible avec le procédé de gravure chimique en phase de liquide à cause de l'effet de rinçage de la surface du substrat qui se produit dans ce cas. De même, les gravures par jets ioniques ont un effet mécanique de bombardement ionique qui permet d'éliminer les impuretés qui ne réagissent pas chimiquement.

Une solution envisageable pour résoudre le problème précédent consiste à réaliser une étape de préparation de surface avant épitaxie au moyen d'un agent choisi pour réagir avec les impuretés tout en produisant des composés volatils. Encore faut-il que cet agent ne réagisse pas avec les autres éléments du substrat. Ainsi pour éliminer les impuretés de types métalloïdes tels que le silicium, le carbone, l'oxygène, ou le soufre, on pourrait utiliser un jet composé d'une substance réductrice tel que l'hydrogène atomique. Cette solution n'est toutefois pas satisfaisante car la substance réductrice réagira généralement avec d'autres éléments du substrat que l'on ne souhaite pas éliminer. Ainsi, dans le cas où le substrat est un alliage semiconducteur III-V tel que InP, l'hydrogène atomique réagit avec le phosphore si la température du substrat est supérieure à 300°C. Or, dans le cas de l'alliage InP, les opérations d'épitaxie ou de gravure par PCl₃ doivent s'effectuer à une température du substrat voisine de 500°C. Ainsi, la préparation envisagée ci-dessus permet difficilement d'enchaîner des opérations de gravure et de reprise d'épitaxie.

Aussi l'invention a pour but d'améliorer les procédés de gravure utilisés jusqu'à présent notamment en vue de simplifier les opérations technologiques nécessaires à la réalisation de séquences de gravure et de recroissance et ainsi d'obtenir des gains de temps de fabrication des produits industriels.

Dans ce but, l'invention a pour objet un procédé de gravure d'un substrat ou d'une couche épitaxiale déposée sur un substrat composé(e) au moins de deux éléments aptes à réagir chacun avec au moins deux substances d'apport de natures différentes pour former des composés volatils de natures différentes, caractérisé en ce qu'il consiste :
- à produire dans l'ultravide au moins deux jets chimiques simultanés, convergeant vers ledit substrat ou ladite couche épitaxiale et constitués respectivement par au moins lesdites deux substances d'apport et
- à maintenir ladite couche à une température suffisante pour imposer l'évaporation des produits résultants des réactions entre lesdits éléments de substrat et les substances desdits jets chimiques.

L'efficacité du procédé peut s'expliquer par les conditions particulières de l'ultravide. En effet, l'ultravide est par définition un vide suffisant pour que le libre parcourt moyen des molécules ou atomes constituant chaque jet soit de l'ordre de la distance séparant la source du jet à la surface du substrat. Ainsi, quelles que soient leurs compositions, des jets simultanés ont une très faible probabilité de réagir entre eux avant d'atteindre la surface du substrat. De plus, au niveau du substrat, la probabilité de réactions entre les composants de chaque jet avec les éléments du substrat est bien plus élevée que celle des réactions des composants des jets entre eux.

Le choix des substances d'apport sera évidemment fonction de la composition de la couche à graver : composition du substrat ou de la couche épitaxiale et nature des impuretés qui s'y trouvent volontairement ou non. Ce choix tiendra compte également des possibilités d'évaporation des produits de réaction.

Il sera ainsi particulièrement avantageux de choisir au moins deux substances d'apport aptes à agir respectivement sur des éléments métalloïdes et sur des éléments métalliques. Une telle combinaison permet en général d'obtenir une gravure complète quelle que soit la composition de la couche à graver.

Le procédé selon l'invention pourra s'appliquer notamment à la fabrication des composants photoniques ou optoélectroniques utilisant des alliages semiconducteurs de types III et V où les impuretés sont généralement de types métalloïdes, tels que le carbone, le soufre ou l'oxygène. Dans ce cas, l'un des jets chimiques sera avantageusement un jet d'atome d'hydrogène, un autre jet étant un jet d'halogénure.

Un exemple détaillé d'application et de mise en oeuvre du procédé selon l'invention sera donné dans la suite de la description en référence aux figures.
- la figure 1 représente un réacteur d'épitaxie par jets moléculaires.
- la figure 2 représente une cellule de génération d'hydrogène atomique utilisée dans le réacteur de la figure 1.

Le procédé de gravure selon l'invention a été mis en oeuvre en particulier dans le cas de composés des éléments Ga, In, As, P sur substrat d'InP qui sont couramment utilisés pour la fabrication des composants photoniques et optoélectroniques. La gravure a été effectuée au moyen d'un jet moléculaire de trichlorure de phosphore PCl₃ et d'un jet d'hydrogène atomique. Les deux jets sont dirigés vers le substrat porté à haute température (entre 400 et 600°C).

Le trichlorure réagit avec les éléments de type métallique, c'est-à-dire l'indium et le gallium pour le substrat et les impuretés métalliques telles que le béryllium, le zinc, ou le fer qui sont souvent utilisés comme dopants.

Le flux d'hydrogène atomique réagit avec les métalloïdes pour former des composants volatils avec le carbone (CH4, CH3...), le soufre (H₂S), l'oxygène (H₂0) et d'autres composés métalloïdes qui n'ont pu être éliminés par le trichlorure.

Il est à noter que les deux flux agissent de manière complémentaire mais n'attaquent pas les masques diélectriques couramment utilisés, tel que ceux constitués de nitrure ou d'oxyde de silicium. Il est donc possible d'effectuer la gravure de manière localisée.

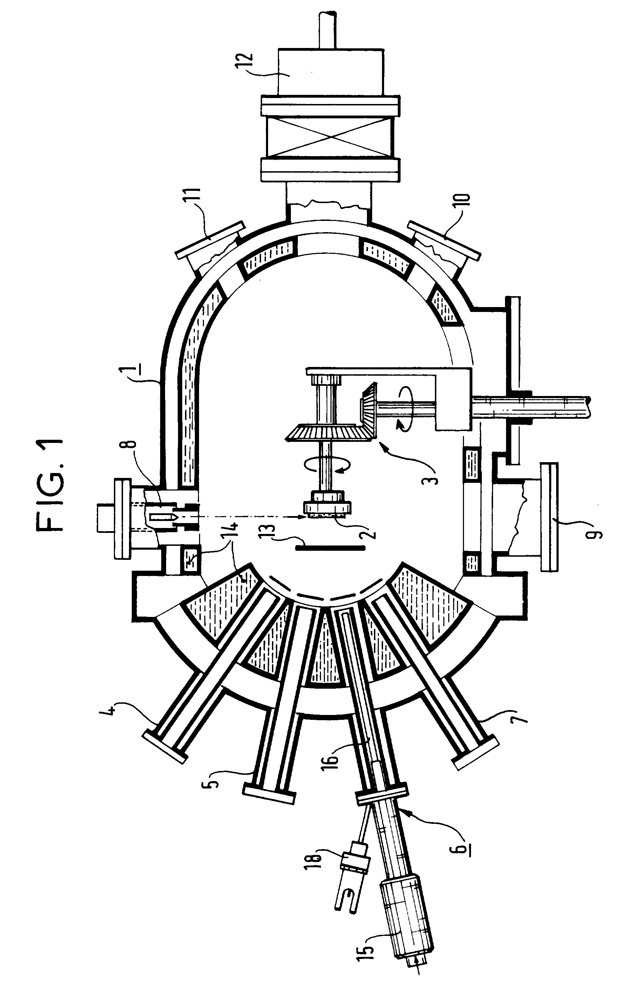

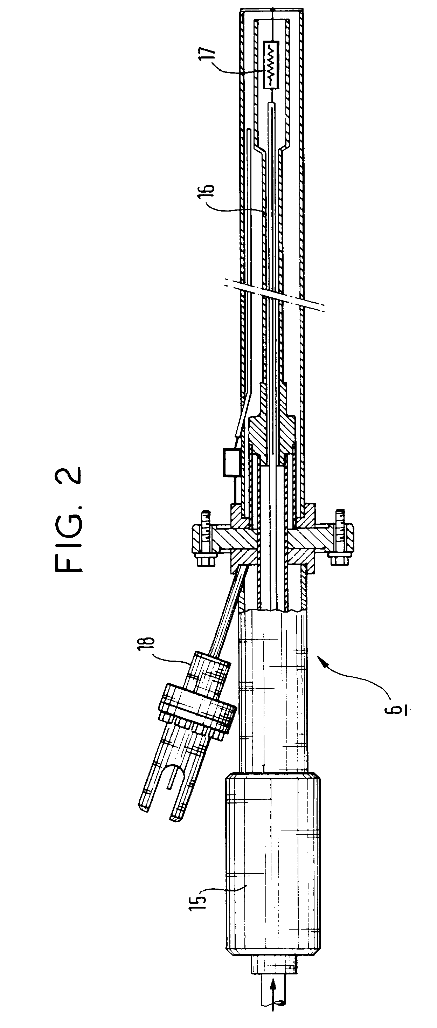

Le procédé selon l'invention peut être mis en oeuvre au moyen d'une installation normalement prévue pour l'épitaxie par jets moléculaires. La figure 1 représente schématiquement en vue de dessus les principaux éléments d'une telle installation. Elle est composée d'une chambre d'épitaxie 1 prévue pour supporter un vide très poussé. A l'intérieur de la chambre est disposé un manipulateur de substrat 3 portant le substrat 2 à traiter et muni de moyens de chauffage. En fonctionnement, le manipulateur 3 est orienté de façon à placer la surface du substrat en vis-à-vis de cellules d'effusion 4, 5, 6, 7 associées à des écrans escamotables individuels. Chaque cellule comporte normalement un creuset d'évaporation muni d'un four dans lequel est placée la substance que l'on souhaite déposer à la surface du substrat. Pour la mise en oeuvre de l'invention, l'une des cellules 6 est une source d'atomes d'hydrogène qui sera décrite plus en détail en référence à la figure 2.

De façon classique, le réacteur comporte également un écran principal 13 escamotable et un canon à électron 8 associé à un écran fluorescent 9 servant au contrôle de l'état de surface du substrat par le procédé de diffraction d'électrons en incidence rasante. Des réservoirs d'azote 14 sont d'autre part prévus pour assurer le refroidissement de l'intérieur de l'enceinte. Des hublots 10, 11 permettent la surveillance visuelle de l'intérieur de la chambre. Une vanne-sas 12 permet enfin l'introduction et le retrait du substrat porté par le manipulateur 3.

Les cellules 4, 5 et 7 peuvent être de constitution classique, l'une d'entre elles servant à contenir par exemple la substance apte à réagir sur les éléments métalliques du substrat. Pour éliminer les éléments métalloïdes, on utilisera avantageusement un jet d'hydrogène atomique fourni par une cellule spécifique telle que celle qui est décrite à la figure 2.

La cellule est essentiellement composée d'un tube 16 d'amenée d'hydrogène moléculaire relié à une extrémité à un embout 15 et contenu dans un tube protecteur. L'autre extrémité du tube d'amenée 16 contient un filament chauffant alimenté par l'intermédiaire de l'embout 15. Optionnellement, la cellule comporte un thermocouple 18 servant à mesurer la température présente à la sortie du tube 16. Pour obtenir un jet d'atomes d'hydrogène, la température doit être maintenue au-delà de 1500°C.

L'exemple qui vient d'être donné ne doit cependant pas être considéré comme limitatif.

L'invention peut en effet s'appliquer à des substrats de diverses compositions tels que l'arséniure de gallium ou des composés ternaires et quaternaires. Par ailleurs, un équivalent du jet d'hydrogène atomique pourrait être un jet moléculaire d'une substance dégageant de l'hydrogène atomique au contact du substrat. Comme substance ayant cette propriété, on peut citer la tridiméthylaminoarsine As[N(CH₃)₂]₃.

## Revendications

1. Procédé de gravure d'un substrat ou d'une couche épitaxiale déposée sur un substrat, composé(e) au moins de deux éléments de substrat aptes à réagir chacun avec au moins deux substances d'apport de natures différentes pour former des composés volatils de natures différentes, caractérisé en ce qu'il consiste :
- à produire dans l'ultravide au moins deux jets chimiques simultanés, convergeant vers ledit substrat ou ladite couche épitaxiale et constitués respectivement par au moins lesdites deux substances d'apport et
- à maintenir ladite couche à une température suffisante pour imposer l'évaporation des produits résultants des réactions entre lesdits éléments de substrat et les substances desdits jets chimiques.

2. Procédé selon la revendication 1, caractérisé en ce que l'une au moins desdites substances d'apport est apte à agir sur des éléments métalloïdes et une autre au moins desdites substances d'apport est apte à agir sur des éléments métalliques.

3. Procédé selon la revendication 2, caractérisé en ce que ledit substrat étant un alliage semiconducteur de type III-V et contenant des impuretés de type métalloïde, l'un desdits jets chimiques est un jet d'atome d'hydrogène.

4. Procédé selon l'une des revendications 2 ou 3, caractérisé en ce qu'un desdits jets chimiques est un jet d'halogénure.

5. Procédé selon la revendication 4, caractérisé en ce que ledit alliage contenant du phosphore ou de l'arsenic, ledit autre jet contient respectivement du trichlorure de phosphore ou d'arsenic.

6. Procédé selon la revendication 5, caractérisé en ce que la température du substrat et comprise entre 400 et 600 degrés Celsius.
